# EUROPÄISCHE PATENTSCHRIFT

(11) **EP 3 215 651 B1**
(45) Veröffentlichungstag und Bekanntmachung des Hinweises auf die Patenterteilung: **15.12.2021**
(21) Anmeldenummer: 15781950.9
(22) Anmeldetag: 20.10.2015
(51) Int. Cl.: C23C 14/34, C23C 14/35, C23C 14/06, C23C 14/32, C23C 28/04, C23C 28/00, C23C 14/02

(54) **PVD VERFAHREN ZUR HERSTELLUNG EINES SCHNEIDWERKZEUGS MIT MEHRLAGIGER BESCHICHTUNG**
PVD MANUFACTURING PROCESS FOR CUTTING TOOL WITH MULTILAYER COATING
PROCÉDÉ POUR LA PRODUCTION D'UN OUTIL DE COUPE POURVU D'UN REVÊTEMENT MULTICOUCHE DÉPOSÉ EN PHASE VAPEUR

(30) Priorität: 05.11.2014 EP 14191910
(43) Veröffentlichungstag der Anmeldung: 13.09.2017
(73) Patentinhaber: Walter AG, 72072 Tübingen (DE)
(72) Erfinder: SCHIER, Veit, 70771 Echterdingen (DE)
(74) Vertreter: Sandvik
(86) Internationale Anmeldenummer: PCT/EP2015/074277
(87) Internationale Veröffentlichungsnummer: WO 2016/071104

(56) Entgegenhaltungen:
- EP-A1- 2 336 382
- EP-A1- 2 392 688
- EP-A1- 2 653 583
- EP-A2- 2 037 000
- DE-A1-102010 028 558
- JP-A- 2010 115 760
- J VETTER ET AL: "Domino Platform: PVD Coaters for Arc Evaporation and High Current Pulsed Magnetron Sputtering", IOP CONFERENCE SERIES: MATERIALS SCIENCE AND ENGINEERING, Bd. 39, 11. September 2012 (2012-09-11), Seite 012004, XP055040463, ISSN: 1757-8981, DOI: 10.1088/1757-899X/39/1/012004
- None

## Beschreibung

### Gegenstand der Erfindung

Die vorliegende Erfindung betrifft ein Verfahren zur Herstellung eines Werkzeugs mit einem Substrat aus Hartmetall, Cermet, Keramik, Stahl oder Schnellarbeitsstahl und einer darauf im PVD-Verfahren aufgebrachten mehrlagigen Beschichtung mit einer Gesamtdicke von 1 µm bis 20 µm, wobei die mehrlagige Beschichtung eine mittels kathodischem Vakuum-Lichtbogenverdampfen (Arc-PVD) abgeschiedene Anbindungsschicht und eine darüber mittels High Power Impulse Magnetronsputtern (HIPIMS) abgeschiedene Verschleißschutzschicht umfasst.

### Hintergrund der Erfindung

Schneidwerkzeuge wie solche, die beispielsweise zur spanabhebenden Metallbearbeitung eingesetzt werden, bestehen in der Regel aus einem Substrat (Grundkörper) aus Hartmetall, Cermet, Stahl oder Schnellarbeitsstahl mit einer darauf mittels CVD-Verfahren (Chemische Gasphasenabscheidung) oder PVD-Verfahren (Physikalische Gasphasenabscheidung) abgeschiedenen verschleißbeständigen ein- oder mehrlagigen Beschichtung aus metallischen Hartstofflagen. Bei den PVD-Verfahren unterscheidet man zwischen verschiedenen Varianten, beispielsweise Kathodenzerstäubung (Sputter-Abscheidung), kathodisches Vakuum-Lichtbogenverdampfen (Arc-PVD), lonenplattierung, Elektronenstrahlverdampfung und Laserablation. Kathodenzerstäubung, wie Magnetronsputtern, reaktives Magnetronsputtern oder High Power Impulse Magnetronsputtern (HIPIMS), und das Lichtbogenverdampfen zählen zu den am häufigsten für die Beschichtung von Schneidwerkzeugen angewendeten PVD-Verfahren.

Beim kathodischen Vakuum-Lichtbogenverdampfen (Arc-PVD) brennt zwischen der Kammer und dem Target ein Lichtbogen, der das Targetmaterial schmilzt und verdampft. Dabei wird ein großer Teil des verdampften Materials ionisiert und zu dem mit einem negativen Potential (Biaspotential) belegten Substrat hin beschleunigt und auf der Substratoberfläche abgeschieden. Das kathodische Vakuum-Lichtbogenverdampfen (Arc-PVD) zeichnet sich durch eine hohe Beschichtungsrate, dichte Schichtstrukturen, bedingt durch die hohe Ionisation des verdampften Materials, sowie Prozessstabilität aus. Ein wesentlicher Nachteil ist jedoch die verfahrensbedingte Abscheidung von Makropartikeln (Droplets), verursacht durch die Emission von kleinen Metallspritzern, deren Vermeidung äußerst aufwendig ist. Die Droplets führen zu einer unerwünscht hohen Oberflächenrauheit auf den abgeschiedenen Lagen.

Bei der Kathodenzerstäubung (Sputtern) werden aus dem Target durch Beschuss mit energiereichen Ionen Atome oder Moleküle herausgelöst und in die Gasphase überführt, wo sie dann entweder direkt oder nach Umsetzung mit einem Reaktionsgas auf dem Substrat abgeschieden werden. Das Magnetron-unterstützte Kathodenzerstäuben umfasst zwei wesentliche Prozessvarianten, das klassische DC-Magnetronsputterns (DC-MS) und das HIPIMS Verfahren. Beim Magnetronsputtern tritt die beim kathodischen Vakuum-Lichtbogenverdampfen (Arc-PVD) nachteilige Dropletbildung nicht auf. Jedoch sind beim klassischen DC-MS die Beschichtungsraten vergleichsweise niedrig, was höhere Prozessdauern und damit einen ökonomischen Nachteil bedeutet.

Beim High Power Impulse Magnetronsputtern (HIPIMS) wird der Magnetron im gepulsten Modus mit hohen Stromdichten betrieben, was zu einer verbesserten Schichtstruktur in Form von dichteren Schichten, insbesondere Aufgrund einer verbesserten Ionisation des abgesputterten Materials, führt. Die Stromdichten am Target übersteigen beim HIPIMS typischerweise die des klassichen DC-MS.

Mittels DC-MS und HIPIMS abgeschiedene Schichten weisen häufig deutliche strukturelle Unterschiede auf. DC-MS-Schichten wachsen in der Regel in einer kolumnaren Struktur auf dem Untergrund auf. Beim HIPIMS-Verfahren werden hingegen feinkristalline Schichtstrukturen erzielt, die sich im Vergleich zu DC-MS-Schichten durch ein verbessertes Verschleißverhalten und damit verbundene längere Standzeiten auszeichnen. HIPIMS-Schichten sind in der Regel härter als die kolumnaren DC-MS-Schichten, zeigen aber auch Nachteile hinsichtlich ihrer Haftung auf vielen Untergründen.

Die EP 2 653 583 beschreibt ein Beschichtungsverfahren zur Abscheidung eines aus im Wesentlichen drei Lagen bestehenden Schichtsystems mittels PVD, wobei das Schichtsystem übereinander eine mittels kathodischem Vakuum-Lichtbogenverdampfen (Arc-PVD) von einem Verdampfungsmaterial (Target) M1 abgeschiedene Kontaktschicht S1, eine mittels HIPIMS von einem Entladungsmaterial (Target) M2 abgeschiedene Deckschicht S3 und dazwischen eine im parallelen Betrieb von Arc-PVD und HIPIMS von sowohl dem Verdampfungsmaterial M1 als auch dem Entladungsmaterial M2 abgeschiedene Zwischenschicht S2 aufweist. Mit dem Schichtsystem soll eine gegenüber Vergleichsbeschichtungen mit im Prinzip gleicher chemischer Zusammensetzung niedrigere Oberflächenrauheit erzielt werden.

Die WO 2013/068080 beschreibt ein Verfahren zum Herstellen eines Schichtsystems mittels HIPIMS, bei dem durch alternierende Anwendung längerer und kürzerer Pulsdauern HIPIMS-Schichten mit abwechselnd feinerer und gröberer Körnigkeit abgeschieden werden. Ein solches Wechselschichtsystem soll gute Verschleißeigenschaften aufweisen.

### Aufgabe

Die Aufgabe der vorliegenden Erfindung bestand darin, ein Verfahren zur Herstellung eines Werkzeugs mit einer Verschleissschutzbeschichtung bereitzustellen, welches die Vorteile bekannter Schichtsysteme, insbesondere die Vorteile von im HIPIMS-Verfahren abgeschiedenen Schichten, aufweist und gleichzeitig die aus dem Stand der Technik bekannten Nachteile, insbesondere ungenügende Haftung, überwindet.

### Beschreibung der Erfindung

Gelöst wird diese Aufgabe erfindungsgemäß durch ein Verfahren gemäß der angehängten Patentansprüche.

Die Offenbarung beschreibt ein Werkzeug mit einem Substrat aus Hartmetall, Cermet, Keramik, Stahl oder Schnellarbeitsstahl und einer darauf im PVD-Verfahren aufgebrachten mehrlagigen Beschichtung mit einer Gesamtdicke von 1 µm bis 20 µm, wobei die mehrlagige Beschichtung eine Anbindungsschicht und eine unmittelbar darüber abgeschiedene Verschleißschutzschicht umfasst,
- wobei die Anbindungsschicht mittels kathodischem Vakuum-Lichtbogenverdampfen (Arc-PVD) abgeschieden und mehrlagig ausgebildet ist, wobei unmittelbar übereinander angeordnete Lagen der Anbindungsschicht unterschiedliche Zusammensetzungen aufweisen und wobei die mehreren Lagen der Anbindungsschicht jeweils von Carbiden, Nitriden, Oxiden, Carbonitriden, Oxicarbiden, Carboxinitriden von wenigstens zwei verschiedenen Metallen, ausgewählt unter Ti, V, Cr, Zr, Nb, Mo, Ru, Hf, Ta, W, Al, Si, Y, Li und B, und festen Lösungen davon gebildet sind, und
- die Verschleißschutzschicht mittels High Power Impulse Magnetronsputtern (HIPIMS) abgeschieden und einlagig oder mehrlagig ausgebildet ist, wobei die eine oder mehreren Lagen der Verschleißschutzschicht jeweils von Carbiden, Nitriden, Oxiden, Carbonitriden, Oxicarbiden, Carboxinitriden von wenigstens zwei verschiedenen Metallen, ausgewählt unter Ti, V, Cr, Zr, Nb, Mo, Ru, Hf, Ta, W, AI, Si, Y, Li und B, und festen Lösungen davon gebildet sind.

Die mittels HIPIMS-Verfahren abgeschiedene Verschleißschutzschicht trägt wesentlich zur Leistung des erfindungsgemäßen Werkzeugs bei, insbesondere in metallbearbeitenden Zerspanungsverfahren. Mittels HIPIMS-Verfahren abgeschiedene Beschichtungen zeichnen sich durch feine Schichtstrukturen und damit verbunden durch hohe Härten und hohe Elastizitätsmodule (E-Module) aus. Die Vickers-Härte einer mittels HIPIMS abgeschiedenen Lage, z. B. einer TiAIN-Lage, kann beispielsweise im Bereich von 3000 bis 4500 HV liegen. Der E-Modul kann bei solchen Lagen im Bereich von 400 bis 550 GPa liegen. Demgegenüber weisen z. B. Hartmetallsubstrate Vickers-Härten in der Größenordnung von 1300 bis 2400 HV auf. Darüber hinaus besitzen mit HIPIMS abgeschiedene Schichten deutlich glattere Oberflächen als mit Arc-PVD abgeschiedene Schichten, was Vorteile bei der Metallbearbeitung, z. B. hinsichtlich der Spanabführung hat.

Große Unterschiede zwischen den Härten am Übergang vom Substrat zur Beschichtung oder von einer Schicht zur darüber angeordneten nächsten Schicht verschlechtern die Haftung der Schicht auf dem Untergrund und führen zu frühzeitiger Ablösung der Beschichtung, schnellerem Verschleiß und damit geringeren Standzeiten des Werkzeugs.

Das Vorsehen von Anbindungsschichten zur Verbesserung der Haftung einer Verschleißschutzschicht auf dem Substrat ist grundsätzlich bekannt. Häufig weisen Anbindungsschichten Komponenten der darunter und der darüber angeordneten Materialien auf, um eine Schicht auszubilden, die hinsichtlich Zusammensetzung und Mikrostruktur zwischen denjenigen der darunter und der darüber angeordneten Schichten liegt und dadurch eine Haftungsvermittlung ausübt.

Es wurde nun überraschend gefunden, dass sich besondere Vorteile, insbesondere hinsichtlich der Haftung einer mittels HIPIMS abgeschiedenen Verschleißschutzschicht, gemäß der vorliegenden Erfindung mit einer erfindungsgemäß ausgebildeten Anbindungsschicht erzielen lassen, die mittels kathodischem Vakuum-Lichtbogenverdampfen (Arc-PVD) abgeschieden und mehrlagig ausgebildet ist und bei der unmittelbar übereinander angeordnete Lagen unterschiedliche Zusammensetzungen aufweisen.

Wie bereits ausgeführt, weist eine mittels HIPIMS abgeschiedene Verschleißschutzschicht in der Regel eine deutlich höhere Vickers-Härte auf als beispielsweise ein übliches WC-Co-Hartmetallsubstrat. Der große Härteunterschied kann dazu führen, dass eine direkt auf dem Substrat oder einer anderen Schicht mit geringer Härte abgeschiedene HIPIMS-Schicht schlecht haftet und es zu frühem Ablösen der Verschleißschutzschicht und schnellem Verschleiß des Werkzeugs kommt. Das HIPIMS-Verfahren erlaubt es nicht, die Härte der abgeschiedenen Verschleißschutzschicht beliebig an diejenige des Substrates oder einer anderen darunter angeordneten Schicht anzupassen, um dieses Haftungsproblem zu mindern. Eine Herabsetzung der Härte der Verschleißschutzschicht ist häufig auch nicht erwünscht, da gerade eine hohe Härte der Verschleißschutzschicht in vielen Metallbearbeitungsverfahren vorteilhaft ist.

Die im HIPIMS-Verfahren abgeschiedene Verschleißschutzschicht kann selbst einlagig oder mehrlagig sein. Eine mehrlagige HIPIMS-Verschleißschutzschicht kann durch Variation der Zusammensetzungen der Lagen und/oder der Abscheidungsparameter mit einem Gradienten der Härte innerhalb der HIPIMS-Verschleißschutzschicht ausgebildet werden, so dass die Schicht im Bereich der Anbindung an die Oberfläche der Anbindungsschicht eine der Anbindungsschicht ähnliche Härte aufweist, und die Härte zur Oberfläche der HIPIMS-Verschleißschutzschicht hin weiter zunimmt. Auf diese Weise sind erfindungsgemäß HIPIMS-Verschleißschutzschichten mit besonders hoher Härte und trotzdem überragender Anbindung herstellbar. In einer erfindungsgemäß besonders bevorzugten Ausführungsform ist daher nicht nur die Arc-PVD-Anbindungsschicht mehrlagig ausgebildet, sondern auch die HIPIMS-Verschleißschutzschicht.

Durch die Kombination der erfindungsgemäß mittels HIPIMS abgeschiedenen Verschleißschutzschicht mit der erfindungsgemäßen mehrlagigen Anbindungsschicht konnten überraschenderweise die aus dem Stand der Technik bekannten Nachteile, insbesondere ungenügende Haftung der HIPIMS-Schicht, überwunden und vergleichsweise hohe Standzeiten der Werkzeuge erzielt werden.

Zusammensetzungen der Lagen der Anbindungsschicht haben sich als besonders vorteilhaft für die Verbesserung der Anbindung der HIPIMS-Verschleißschutzschicht erwiesen. Es wird angenommen, dass dies darauf zurückzuführen ist, dass diese Hartstoffe alle ein ähnliches kubisch-flächenzentriertes Gefüge, hohe Härten und hohe E-Module aufweisen.

Die mehrlagige Anbindungsschicht weist wenigstens 2 übereinander angeordnete Lagen unterschiedlicher Zusammensetzungen auf, wobei im Sinne der vorliegenden Erfindung die Lagen, welche die gleichen Elemente enthalten, nämlich Ti, Al und N, aber unterschiedliche stöchiometrische Zusammensetzungen aufweisen als "Lagen unterschiedlicher Zusammensetzungen" definiert sind, beispielsweise übereinander angeordnete Lagen von Ti_{0,33}Al_{0,67}N und Ti_{0,5}Al_{0,5}N. In einer bevorzugten Ausführungsform der Erfindung weist die mehrlagige Anbindungsschicht wenigstens 4, vorzugsweise wenigstens 10 übereinander angeordnete Lagen auf. Es hat sich überraschend gezeigt, sich durch die Erhöhung der Anzahl der Einzellagen die Variation bzw. Steigerung der Härte im Verlauf senkrecht zur Substratoberfläche verbessern und eine geringer abgestufte Graduierung des Härteverlaufs innerhalb der Anbindungsschicht erzielen lässt. Gleichzeitig wird auch die Rissbeständigkeit der Anbindungsschicht bei der metallbearbeitenden Anwendung verbessert. Es wird angenommen, dass dies auf die Erhöhung der Anzahl der Lagengrenzen zurückzuführen ist, an denen auftretende Rissenergien abgeleitet werden können, wodurch eine Rissfortsetzung effektiver verhindert wird. Des Weiteren ist es bevorzugt, wenn die Anbindungsschicht höchstens 300, vorzugsweise höchstens 100, besonders bevorzugt höchstens 50 übereinander angeordnete Lagen aufweist. Ist die Anzahl der Lagen der Anbindungsschicht bei gegebener Dicke der Anbindungsschicht, welche zweckmäßigerweise nicht mehr als etwa 1µm betragen sollte, zu hoch, so werden die Einzellagen sehr dünn bis hin zu wenigen Atomlagen, so dass in der Folge die erwünschten Lagengrenzen nicht mehr definiert werden, was die Rissbeständigkeit beeinträchtigt.

In einer weiteren bevorzugten Ausführungsform der Erfindung ist die mehrlagige Anbindungsschicht so ausgebildet, dass innerhalb der Schicht die Vickers-Härte senkrecht zur Substratoberfläche in der Richtung vom Substrat zur Verschleißschutzschicht ansteigt und die Vickers-Härten innerhalb der mehrlagigen Anbindungsschicht im Bereich von 1800 HV bis 3500 HV, vorzugsweise 2000 HV bis 3300 HV, liegen. Der Anstieg der Härte beschreibt einen Gradienten über die Gesamtdicke der Anbindungsschicht, der linear, nicht-linear oder auch abgestuft verlaufen kann.

Vorteilhaft ist es, am Übergang vom Substrat oder einer Schicht unter der Anbindungsschicht zur Anbindungsschicht einerseits und am Übergang von der Anbindungsschicht zur HIPIMS-Verschleißschutzschicht andererseits jeweils möglichst geringe Differenzen zwischen den Härten zu erzielen. Die erfindungsgemäße mehrlagige Anbindungsschicht erlaubt das Einstellen der Härtewerte innerhalb der Schicht, was in einer einlagigen Anbindungsschicht nicht in dem Ausmaß wie in der mehrlagigen Anbindungsschicht möglich wäre.

Durch die erfindungsgemäße Erhöhung der Vickers-Härte innerhalb der Anbindungsschicht in der Richtung vom Substrat zur Verschleißschutzschicht kann mit Vorteil ein großer Härteunterschied zwischen Substrat oder einer Schicht unter der Anbindungsschicht und der HIPIMS-Verschleißschutzschicht ausgeglichen werden. Dadurch konnte eine verbesserte Haftung der HIPIMS-Verschleißschutzschicht und damit auch verbessere Standzeiten der Werkzeuge erzielt werden.

Ein Mittel zum Variieren der Härte innerhalb der Anbindungsschicht ist die Veränderung der Beschichtungsparameter während des Abscheidungsverfahrens, hier insbesondere die Veränderung des Biaspotentials während des Abscheidungsprozesses. Eine Erhöhung des Biaspotentials während der Abscheidung führt in der Regel zu einer Steigerung der Härte.

Die ausschließliche Veränderung des Biaspotentials während der Abscheidung einer einlagigen Anbindungsschicht wäre jedoch in der Regel nicht ausreichend, um einen Härtegradienten innerhalb der Schicht zu liefern, der die Härtedifferenz zwischen einem üblichen Hartmetallsubstrat mit Vickers-Härten in der Größenordnung von etwa 1300 bis 2400 HV und einer mittels HIPIMS abgeschiedenen Lage, z. B. einer TiAIN-Lage, im Bereich von etwa 3000 bis 4500 HV zu überbrücken. Durch die Variation des Biaspotentials ließe sich innerhalb einer einlagigen Anbindungsschicht eine Veränderung der Härte um vermutlich nicht mehr als etwa 200 bis 300 HV erreichen. Erst die Kombination der Veränderung der Abscheidungsparameter, insbesondere des Biaspotentials, mit der erfindungsgemäßen Ausgestaltung der mehrlagigen Anbindungsschicht, welche dadurch gekennzeichnet ist, dass unmittelbar übereinander angeordnete Lagen der Anbindungsschicht unterschiedliche Zusammensetzungen aufweisen, ermöglicht die Ausbildung eines Härtegradienten innerhalb der Anbindungsschicht über eine breite Härtedifferenz zwischen beispielsweise dem Substrat und der HIPIMS-Verschleißschutzschicht.

In einer weiteren bevorzugten Ausführungsform der Erfindung ist die mehrlagige Anbindungsschicht so ausgebildet, dass innerhalb der mehrlagigen Anbindungsschicht der Elastizitätsmodul (E-Modul) senkrecht zur Substratoberfläche in der Richtung vom Substrat zur Verschleißschutzschicht ansteigt und die Werte des Elastizitätsmoduls (E-Modul) innerhalb der mehrlagigen Anbindungsschicht im Bereich von 380 GPa bis 550 GPa, vorzugsweise von 420 GPa bis 500 GPa, liegen.

Zweckmäßigerweise weist die mehrlagige Anbindungsschicht senkrecht zur Substratoberfläche eine Dicke im Bereich von 0,01 µm bis 1 µm, vorzugsweise 0,05µm bis 0,6 µm, besonders bevorzugt 0,1 µm bis 0,4 µm auf. Ist die Anbindungsschicht zu dünn, wird keine ausreichende Bedeckung der unter der Anbindungsschicht angeordneten Oberfläche und somit auch keine ausreichende Verbesserung der Haftung der HIPIMS-Verschleißschutzschicht erreicht.

Die Oberflächenrauheit der Arc-PVD-Anbindungsschicht nimmt in der Regel mit ihrer Dicke zu. Die Abscheidung der Verschleißschutzschicht im HIPIMS-Verfahren soll unter anderem eine glatte Oberfläche schaffen, indem sie die Oberflächenrauheit der Arc-PVD-Anbindungsschicht zumindest teilweise ausgleicht. Ist die Anbindungsschicht jedoch zu dick, schlägt ihre Oberflächenrauheit stark an die Oberfläche des Gesamtverbandes aus Arc-PVD-Anbindungsschicht und HIPIMS-Verschleißschutzschicht durch, so dass eine unerwünscht hohe Oberflächenrauheit der HIPIMS-Verschleißschutzschicht entsteht.

Die Dicke der Einzellagen, welche die gesamte Anbindungsschicht bilden, entspricht bei in etwa gleich dicken Einzellagen der Dicke der Anbindungsschicht, geteilt durch die Anzahl der Einzellagen. Typischerweise haben die Einzellagen der Anbindungsschicht eine Dicke im Bereich von 20 bis 200 nm.

Vom Umfang der vorliegenden Erfindung umfasst ist auch eine Variation der Dicken der Einzellagen innerhalb der Anbindungsschicht. Dies lässt sich beispielsweise durch Veränderung des Verdampferstroms während der Abscheidung der mehrlagigen Anbindungsschicht erreichen. Dadurch kann ebenfalls eine Steigerung der Härte innerhalb der Anbindungsschicht erzielt werden. Weisen in der Anbindungsschicht die übereinander angeordneten Lagen mit unterschiedlicher Zusammensetzung auch unterschiedliche Härten auf, so kann eine Erhöhung der Dicken der Einzellagen aus dem härteren Material und/oder Verringerung der Dicken der Einzellagen aus dem weicheren Material einen Härtegradienten innerhalb der Anbindungsschicht schaffen oder dazu beitragen. In der Regel wird ein von einem TiAl (50:50)-Target abgeschiedenes Ti_{0,5}A1_{0,5}N-Material weicher sein als ein von einem TiAl (33:67)-Target abgeschiedenes Ti_{0,33}Al_{0,67}N-Material. Eine Steigerung der Härte innerhalb einer TiAIN-Anbindungsschicht ließe sich somit durch Erhöhung der Lagendicken des Ti_{0,33}Al_{0,67}N-Materials und/oder Verringerung der Lagendicken des Ti_{0,5}Al_{0,5}N-Materiais erzielen, indem die Verdampferströme an den jeweiligen Targets während der Abscheidung entsprechend variiert werden.

Die ein- oder mehrlagige Verschleißschutzschicht weist zweckmäßigerweise eine Dicke im Bereich von 0,4 µm bis 20 µm, vorzugsweise 1 µm bis 10 µm, besonders bevorzugt 1,5 µm bis 5 µm auf.

In einer weiteren Ausführungsform der Erfindung beträgt das Verhältnis der Dicke der ein- oder mehrlagigen Verschleißschutzschicht zur Dicke der mehrlagigen Anbindungsschicht wenigstens 2,0, vorzugsweise wenigstens 2,3, besonders bevorzugt wenigstens 3,5, ganz besonders bevorzugt wenigstens 4,0. Ist die Arc-PVD-Anbindungsschicht im Verhältnis zur HIPIMS-Verschleißschutzschicht zu dick, so erhält der Gesamtschichtverbund aus Arc-PVD-Anbindungsschicht und HIPIMS-Verschleißschutzschicht eine unerwünscht hohe Oberflächenrauheit, wie oben ausgeführt.

In einer weiteren Ausführungsform umfassen die Lagen der mehrlagigen Anbindungsschicht alternierende Lagen aus Titan-Aluminiumnitrid mit unterschiedlichen Zusammensetzungen, wobei sich Lagen mit einem Verhältnis von Ti:Al von (30 bis 36):(70 bis 64) und Lagen mit einem Verhältnis von Ti:Al von (40 bis 60):(60 bis 40), vorzugsweise von (47 bis 53):(53 bis 47) abwechseln. Zweckmäßigerweise sollte der Unterschied des Al-Gehaltes zwischen den Lagen wenigstens 5 Atom-% Al betragen.

Die HIPIMS-Verschleißschutzschicht kann einlagig oder mehrlagig ausgebildet sein. In einer bevorzugten Ausführungsform der Erfindung ist die Verschleißschutzbeschichtung mehrlagig und weist wenigstens 2, 4 oder 10 und höchstens 50, 100 oder 300, übereinander angeordneten Lagen auf. Wie oben ausgeführt, kann eine mehrlagige HIPIMS-Verschleißschutzschicht durch Variation der Zusammensetzungen der Lagen und/oder der Abscheidungsparameter mit einem Gradienten der Härte innerhalb der HIPIMS-Verschleißschutzschicht ausgebildet werden, so dass die Schicht im Bereich der Anbindung an die Oberfläche der Anbindungsschicht eine der Anbindungsschicht ähnliche Härte aufweist und die Härte zur Oberfläche der HIPIMS-Verschleißschutzschicht hin weiter zunimmt. Auf diese Weise sind erfindungsgemäß HIPIMS-Verschleißschutzschichten mit besonders hoher Härte und trotzdem überragender Anbindung herstellbar.

Die Kombination aus Anbindungsschicht und Verschleißschutzschicht kann die Gesamtbeschichtung eines Werkzeugs bilden. Jedoch umfasst die Erfindung auch Werkzeuge, bei denen zwischen dem Substrat und der Anbindungsschicht eine oder mehrere weitere Hartstofflagen und/oder Metalllagen vorgesehen sind, vorzugsweise TiN oder metallisches Ti. Des Weiteren können über der Verschleißschutzschicht eine oder mehrere weitere Lagen vorgesehen sein, vorzugsweise eine oder mehrere Dekorlagen aus TiN, TiCN, ZrN oder anderen für Dekorlagen bekannten Hartstoffen. Solche Dekorlagen sind sehr dünn, üblicherweise zwischen 0,2 und 1 µm, und haben neben der dekorativen Funktion in der Regel auch eine Indikatorfunktion, da eine Abnutzung der Dekorlage anzeigt, dass und ggf. in welchem Ausmaß ein Werkzeug bereits benutzt wurde. Es können mit Vorteil auch weitere Lagen mit reibarmer Oberfläche vorgesehen sein, welche beispielsweise bei der spanenden Metallbearbeitung für eine verbesserte Spanabführung sorgen, z. B. diamantartige oder graphitische Kohlenstoffschichten. Auch Oxide können als äußerste Lagen aufgebracht werden, beispielsweise Aluminiiumoxid oder Aluminium-Chromoxid, welche den tribochemischen Verschleiß vermindern können.

Die Erfindung umfasst auch ein Verfahren zur Herstellung eines beschichteten Werkzeugs mit den Stufen, in denen man
- einen Grundkörper aus Hartmetall, Cermet, Keramik, Stahl oder Schnellarbeitsstahl im PVD-Verfahren mit einer mehrlagigen Beschichtung mit einer Gesamtdicke von 1 µm bis 20 µm versieht, wobei die mehrlagige Beschichtung eine Anbindungsschicht und eine unmittelbar darüber abgeschiedene Verschleißschutzschicht umfasst,
wobei man die Anbindungsschicht mittels reaktivem oder nicht-reaktivem kathodischem Vakuum-Lichtbogenverdampfen (Arc-PVD) mehrlagig ausbildet, wobei jeweils zwei unmittelbar übereinander angeordnete Lagen unterschiedliche Zusammensetzungen aufweisen und die mehreren Lagen der Anbindungsschicht alternierende Lagen aus Titan- Aluminiumnitrid mit unterschiedlichen Zusammensetzungen umfassen, wobei sich Lagen mit einem Verhältnis von Ti:Al von (30 bis 36):(70 bis 64) und Lagen mit einem Verhältnis von Ti:Al von (40 bis 60):(60 bis 40), vorzugsweise von (47 bis 53):(53 bis 47) abwechseln, und wobei man die Verschleißschutzschicht mittels High Power Impulse Magnetronsputtern (HIPIMS) einlagig oder mehrlagig ausbildet, wobei die eine oder mehreren Lagen der Verschleißschutzschicht jeweils von Carbiden, Nitriden, Oxiden, Carbonitriden, Oxicarbiden, Carboxinitriden von wenigstens zwei verschiedenen Metallen, ausgewählt unter Ti, V, Cr, Zr, Nb, Mo, Ru, Hf, Ta, W, Al, Si, Y, Li und B, und festen Lösungen davon gebildet werden.

Wie bereits oben ausgeführt wurde, ist es vorteilhaft, wenn am Übergang vom Substrat oder einer Schicht unter der Anbindungsschicht zur Anbindungsschicht einerseits und am Übergang von der Anbindungsschicht zur HIPIMS-Verschleißschutzschicht andererseits jeweils möglichst geringe Differenzen zwischen den mechanischen Eigenschaften vorliegen, insbesondere der Härte (Vickers-Härte). Durch Veränderung der Abscheidungsparameter im Verlauf der Abscheidung der mehrlagigen Anbindungsschicht, insbesondere durch Veränderung des Biaspotentials, lässt sich die Härte innerhalb der Anbindungsschicht über einen weiten Bereich variieren, um die Haftung der HIPIMS-Verschleißschutzschicht auf der Anbindungsschicht zu verbessern. Dies wäre in einer einlagigen Anbindungsschicht nicht im Umfang der vorliegenden Erfindung möglich.

In einer bevorzugten Ausführungsform des erfindungsgemäßen Verfahrens werden daher die Abscheidungsparameter für die Abscheidung der mehrlagigen Anbindungsschicht variiert, so dass innerhalb der mehrlagigen Anbindungsschicht die Vickers-Härte senkrecht zur Substratoberfläche in der Richtung vom Substrat zur Verschleißschutzschicht ansteigt und die Vickers-Härten innerhalb der mehrlagigen Anbindungsschicht im Bereich von 1800 HV bis 3500 HV, vorzugsweise 2000 HV bis 3300 HV, liegen, wobei die während der Abscheidung der mehrlagigen Anbindungsschicht zu variierenden Abscheidungsparameter wenigstens das Biaspotential umfassen.

### Beispiele

Die Beschichtungen wurden in einer 6-Flansch-PVD-Anlage HTC 1000 (Firma Hauzer, Venlo, Niederlande) hergestellt. Die Substrate wurden auf Drehtellern rotiert. Für das HIPIMS-Verfahren wurde ein Plasmagenerator der Firma Zpulser LLC, Mansfiled, USA, verwendet. In den Beispielen angegebene Schicht- und Lagendicken sowie Härte- und E-Modul-Werte wurden jeweils auf der Freifläche des beschichteten Werkzeugkörpers gemessen.

Die hierin im HIPIMS-Verfahren eingesetzte Pulssequenz (Pulsfile 60) umfasste folgende Teilsequenzen:
1. 5x 34 µs / 6 µs (an / aus)
2. 3x 24 µs / 6 µs (an / aus)
3. 4x 14 µs / 8 µs (an / aus)
4. 50x 10 µs / 12 µs (an /aus)

### Beispiel 1:

### Substrat:

| | |
|---|---|
| Hartmetall: | WC (Feinkorn) - 10 Gew.-% Co |
| Vickers-Härte: | 2000 HV |
| E-Modul: | 500 GPa |

### Anbindungsschicht (mehrlagig):

| Verfahren: | Arc-PVD |
|---|---|
| Targets: | (1) TiAl (50:50), 100 mm Durchmesser, Reaktorposition 2 |
| | (2) TiAl (33:67), 100 mm Durchmesser, Reaktorposition 5 (gegenüberliegend) |

### Abscheideparameter

Verdampferstrom: 140 A
Center Magnet-Polung Nord vorn
Gesamtdruck: Gradient von 4 bis 10 Pa N₂ über 3 min
Biaspotential: DC, Gradient von 40 bis 60 V über 3 min

### Verschleißschutzschicht (einlagig):

| | |
|---|---|
| Verfahren: | HIPIMS |
| Targets: | TiAl (33:67), 1800 x 200 mm, Reaktorpositionen 3 und 6 (gegenüberliegend) |

### Abscheideparameter

Durchschnittsleistung: 12 kW (pro Target)
Biaspotential: DC, 100 V
Peakleistung: 130 kW
Peakstrom: 160 A
Frequenz: 110 Hz
Pulsfile: 60

Die angegebenen Werte sind Durchschnittswerte, da sich die Plasmabedingungen bei bewegtem Substratteller ständig ändern.

Die abgeschiedene Anbindungsschicht hatte eine Gesamtschichtdicke von 0,2 µm und bestand aus etwa 6 TiAIN-Einzellagen mit abwechselnd unterschiedlichen Zusammensetzungen Ti_{0,5}Al_{0,5}N und Ti_{0,33}Al_{0,67}N (entsprechend den Zusammensetzungen der verwendeten Targets). Die Einzellagen der Anbindungsschicht hatten somit eine Dicke von jeweils etwa 33 nm. Aufgrund der graduellen Variation (Steigerung) des Biaspotentials während der Schichtabscheidung nahm die Vickers-Härte der abgeschiedenen Anbindungsschicht in Richtung vom Substrat nach außen von 2200 HV bei 40 V Biaspotential auf 2900 HV bei 60 V Biaspotential zu. Der E-Modul innerhalb der Anbindungsschicht nahm von 450 GPa bei 40 V Biaspotential auf 480 GPa bei 60 V Biaspotential zu. Gemessen wurden die Eigenschaften Härte und E-Modul an entsprechend hergestellten Schichten, bei deren Abscheidung die hier variierten Parameter jedoch konstant gehalten wurden, beispielsweise konstantes Biaspotential von 40 V, da Messungen von Vickers-Härte und E-Modul an nur wenige Nanometer dünnen Schichtbereichen nicht möglich sind.

Die im HIPIMS-Verfahren abgeschiedene Verschleißschutzschicht hatte eine Gesamtschichtdicke von 2 µm und bestand aus Ti_{0,33}Al_{0,67}N (entsprechend der Zusammensetzung des verwendeten Targets). Die Vickers-Härte der Verschleißschutzschicht betrug 3300 HV, und der E-Modul betrug 480 GPa.

### Beispiel 2:

In diesem Beispiel wurde das gleiche Substrat wie in Beispiel 1 verwendet. Für die mehrlagige Anbindungsschicht wurde zunächst in einer ersten Stufe 1 eine etwa 50 nm dicke Ti_{0,5}Al_{0,5}N-Lage bei einem Biaspotential von 70 V und anschließend in einer zweiten Stufe 2 eine etwa 0,2 µm dicke Schichtfolge aus etwa 6 TiAIN-Einzellagen (ca. 33 nm Einzellagendicke) mit abwechselnd unterschiedlichen Zusammensetzungen Ti_{0,5}Al_{0,5}N und Ti_{0,33}Al_{0,67}N bei einem Biaspotential von 100 V abgeschieden.

### Anbindungsschicht (mehrlagig):

| | |
|---|---|
| Verfahren: | Arc-PVD |

### Stufe 1

| | |
|---|---|
| Target: | TiAl (50:50), 100 mm Durchmesser, Reaktorposition 2 |

### Abscheideparameter

Verdampferstrom: 150 A
Center Magnet-Polung Nord vorn
Gesamtdruck: 4,5 Pa N₂
Biaspotential: DC, 70 V

### Stufe 2

| | |
|---|---|
| Targets: | (1) TiAl (33:67), 100 mm Durchmesser, Reaktorposition 5 |
| | (2) TiAl (50:50), 100 mm Durchmesser, Reaktorposition 2 (gegenüberliegend) |

### Abscheideparameter

Verdampferstrom: 140 A
Center Magnet-Polung Nord vorn
Gesamtdruck: Gradient von 4 bis 10 Pa N₂ über 3 min
Biaspotential: DC, 100 V

### Verschleißschutzschicht (mehrlagig):

| | |
|---|---|
| Verfahren: | HIPIMS |
| Targets: | (1) TiAl (33:67), 1800 x 200 mm, Reaktorposition 3 |
| | (2) TiAl (50:50), 1800 x 200 mm, Reaktorposition 6 (gegenüberliegend) |

### Abscheideparameter

Durchschnittsleistung: 12 kW (pro Target)
Biaspotential: DC, 90 V
Peakleistung: Target (1): 130 kW; Target (2): 140 kW
Peakstrom: Target (1): 160 A; Target (2): 170 A
Frequenz: Target (1): 110 Hz; Target (2): 100 Hz
Reaktivgas: 180 sccm N₂, druckgeregelt, 0,53 Pa (500 sccm Ar)
Pulsfile: 60

Die angegebenen Werte sind Durchschnittswerte, da sich die Plasmabedingungen bei bewegtem Substratteller ständig ändern.

Die Vickers-Härte des in Stufe 2 abgeschiedenen Schichtaufbaus der Anbindungsschicht betrug 3000 HV, und der E-Modul betrug 480 GPa.

Die Vickers-Härte des in Stufe 1 bei einem Biaspotential von 70 V abgeschiedenen Ti_{0,5}Al_{0,5}N-Lage wurde an entsprechend hergestellten Lage mit größerer Dicke gemessen. Sie betrug 2900 HV, und der E-Modul betrug 470 GPa.

Dadurch wurde ein stufenweiser Übergang von der Härte des Substrats zu der höheren Härte des in Stufe 2 abgeschiedenen alternierenden Lagenverbundes geschaffen.

Die im HIPIMS-Verfahren abgeschiedene Verschleißschutzschicht hatte eine Gesamtschichtdicke von 2,7 µm und bestand aus etwa 760 TiAIN-Einzellagen mit abwechselnd unterschiedlichen Zusammensetzungen Ti_{0,5}Al_{0,5}N und Ti_{0,33}Al_{0,67}N (entsprechend den Zusammensetzungen der verwendeten Targets). Die Einzellagen der Verschleißschutzschicht hatten somit eine Dicke von jeweils etwa 3,5 nm. Die Vickers-Härte der Verschleißschutzschicht betrug 3300 HV, und der E-Modul betrug 480 GPa.

### Beispiel 3:

In diesem Beispiel wurde das gleiche Substrat wie in Beispiel 1 verwendet. Die mehrlagige Anbindungsschicht wurde wie in Beispiel 2 abgeschieden.

Für die mehrlagige Verschleißschutzschicht wurde zunächst in einer ersten Stufe 1 eine etwa 10 nm dicke Ti_{0,4}Al_{0,6}N-Lage, in einer zweiten Stufe 2 eine etwa 0,16 µm dicke Schichtfolge aus etwa 8 TiAIN-Einzellagen (ca. 20 nm Einzellagendicke) mit abwechselnd unterschiedlichen Zusammensetzungen Ti_{0,33}Al_{0,67}N und Ti_{0,4}Al_{0,6}N und in einer dritten Stufe 3 eine etwa 1,9 µm dicke Schichtfolge aus etwa 24 TiAIN-Einzellagen (ca. 80 nm Einzellagendicke) mit abwechselnd unterschiedlichen Zusammensetzungen Ti_{0,33}Al_{0,67}N und Ti_{0,4}Al_{0,6}N abgeschieden. Abschließend wurde noch eine 80 nm dicke Dekorlage im HIPIMS-Verfahren aufgebracht.

### Verschleißschutzschicht (mehrlagig):

| | |
|---|---|
| Verfahren: | HIPIMS |

### Stufe 1

| | |
|---|---|
| Target: | TiAl (40:60), 1800 x 200 mm, Reaktorposition 6 |

### Abscheideparameter

Durchschnittsleistung: 12 kW
Biaspotential: DC, 150 V
Peakleistung: 140 kW
Peakstrom: 170 A
Frequenz: 100 Hz
Reaktivgas: 220 sccm N₂, entspricht ca. 0,54 Pa (bei 500 sccm Ar)
Pulsfile: 60

### Stufe 2

| | |
|---|---|
| Targets: | (1) TiAl (33:67), 1800 x 200 mm, Reaktorposition 3 |
| | (2) TiAl (40:60), 1800 x 200 mm, Reaktorposition 6 (gegenüberliegend) |

### Abscheideparameter

Durchschnittsleistung: 115 kW (pro Target)
Biaspotential: DC, 100 V
Peakleistung: Target (1): 135 kW; Target (2): 140 kW
Peakstrom: Target (1): 220 A; Target (2): 220 A
Frequenz: Target (1): 100-120 Hz; Target (2): 90-110 Hz
Reaktivgas: N₂, Druck geregelt 0,53 Pa (bei 500 sccm Ar)
Pulsfile: 60

### Stufe 3

| | |
|---|---|
| Targets: | (1) TiAl (33:67), 1800 x 200 mm, Reaktorposition 3 |
| | (2) TiAl (40:60), 1800 x 200 mm, Reaktorposition 6 (gegenüberliegend) |

### Abscheideparameter

Durchschnittsleistung: 15 kW (pro Target)
Biaspotential: DC, 100 V
Peakleistung: Target (1): 135 kW; Target (2): 140 kW
Peakstrom: Target (1): 170 A; Target (2): 170 A
Frequenz: Target (1): 140 Hz; Target (2): 125 Hz
Reaktivgas: N₂, druckgeregelt 0,53 Pa (bei 500 sccm Ar)
Pulsfile: 60

### Dekorlage

| | |
|---|---|
| Target: | TiAl (33:67), 1800 x 200 mm, Reaktorposition 3 |

### Abscheideparameter

Durchschnittsleistung: 12 kW
Biaspotential: DC, 100 V
Peakleistung: 135 kW;
Peakstrom: 170 A;
Frequenz: 110 Hz;
Reaktivgas: Fluss 220 sccm N₂, entspricht ca.0,54 Pa (bei 500 sccm Ar)
Pulsfile: 60

Die Härte der im HIPIMS-Verfahren abgeschiedenen mehrlagigen Verschleißschutzschicht betrug 3700HV, und der E-Modul betrug 510 GPa.

### Vergleichsbeispiel 1:

In diesem Vergleichsbeispiel wurde eine einlagige TiAIN-Verschleißschutzschicht mittels HIPIMS auf dem gleichen Substrat wie in Beispiel 1 abgeschieden.

### Verschleißschutzschicht:

| | |
|---|---|
| Verfahren: | HIPIMS |
| Targets: | 2x TiAl (33:67), 1800 x 200 mm, Reaktorpositionen 3 und 6 |

### Abscheideparameter

Durchschnittsleistung: 12 kW (pro Target)
Biaspotential: DC, 100 V
Peakleistung: 130 kW
Peakstrom: 160 A
Frequenz: 110 Hz
Pulsfile: 60

Die angegebenen Werte sind Durchschnittswerte, da sich die Plasmabedingungen bei bewegtem Substratteller ständig ändern.

Die im HIPIMS-Verfahren abgeschiedene einlagige TiAIN-Schicht hatte eine Gesamtschichtdicke von 2,2 µm und die Zusammensetzung Ti_{0,33}Al_{0,67}N (entsprechend den Zusammensetzungen der verwendeten Targets). Die Vickers-Härte der Verschleißschutzschicht betrug 3300 HV, und der E-Modul betrug 480 GPa. Die HIPIMS-Lage zeigte eine sehr niedrige Oberflächenrauheit, aber auch niedrige Standzeiten aufgrund schlechter Haftung auf dem Substrat.

### Vergleichsbeispiel 2:

In diesem Vergleichsbeispiel wurde zunächst eine 0,6 µm dicke einlagige TiAIN-Anbindungsschicht mittels Arc-PVD und darüber eine 2 µm dicke einlagige TiAIN-Verschleißschutzschicht mittels HIPIMS wie in Vergleichsbeispiel 1 abgeschieden.

### Anbindungsschicht:

| | |
|---|---|
| Verfahren: | Arc-PVD |
| Targets: | TiAl (50:50), 100 mm Durchmesser, Reaktorposition 2 |

### Abscheideparameter

Verdampferstrom: 140 A
Center Magnet-Polung Nord vorn
Gesamtdruck: Gradient von 4 bis 10 Pa N₂ über 3 min
Biaspotential: DC, 100 V

### Verschleißschutzschicht:

| | |
|---|---|
| Verfahren: | HIPIMS |
| Targets: | TiAl (33:67), 1800 x 200 mm, Reaktorpositionen 3 und 6 (gegenüberliegend) |

### Abscheideparameter

Durchschnittsleistung: 12 kW (pro Target)
Biaspotential: DC, 100 V
Peakleistung: 130 kW
Peakstrom: 160 A
Frequenz: 110 Hz
Pulsfile: 60

Die angegebenen Werte sind Durchschnittswerte, da sich die Plasmabedingungen bei bewegtem Substratteller ständig ändern.

Die Vickers-Härte der Anbindungsschicht betrug 2400 HV, und der E-Modul betrug 450 GPa. Die im HIPIMS-Verfahren abgeschiedene einlagige TiAIN-Schicht entsprach derjenigen gemäß Vergleichsbeispiel 1. Die Beschichtung gemäß Vergleichsbeispiel 2 besaß eine den erfindungsgemäßen Beschichtungen vergleichbare Oberflächenrauheit, jedoch deutlich geringere Standzeiten.

### Vergleichsbeispiel 3:

In diesem Vergleichsbeispiel wurde eine mehrlagige, etwa 2,5 µm dicke Schichtfolge aus etwa 500 TiAIN-Einzellagen (ca. 5 nm Einzellagendicke) mit abwechselnd unterschiedlichen Zusammensetzungen Ti_{0,5}Al_{0,5}N und Ti_{0,33}Al_{0,67}N mittels Arc-PVD abgeschieden, jedoch darüber keine weiteren Schichten. Anders als in den zuvor beschriebenen Beispielen und Vergleichsbeispielen wurde eine ausschließlich für das kathodische Vakuum-Lichtbogenverdampfen (Arc-PVD) ausgelegte Anlage Innova (Firma Balzers, Balzers, Liechtenstein) verwendet.

### Schicht:

| | |
|---|---|
| Verfahren: | Arc-PVD |
| Targets: | (1) TiAl (50:50), Versorgung Mag10, 160 mm Durchmesser, Reaktorpositionen 1, 2, 3, 6 |
| | (2) TiAl (33:67), Versorgung Mag6, 160 mm Durchmesser, Reaktorpositionen 4, 5 |

### Abscheideparameter

Verdampferstrom: jeweils 160 A
Gesamtdruck: 4 Pa N₂
Biaspotential: DC, 60 V

Die Vickers-Härte der mehrlagigen Schicht betrug 3200 HV, und der E-Modul betrug 460 GPa. Die Oberflächenrauheit der Schicht war sehr hoch.

## Patentansprüche

1. Verfahren zur Herstellung eines beschichteten Werkzeugs mit den Stufen, in denen man - einen Grundkörper aus Hartmetall, Cermet, Keramik, Stahl oder Schnellarbeitsstahl im PVD-Verfahren mit einer mehrlagigen Beschichtung mit einer Gesamtdicke von 1 µm bis 20 µm versieht, wobei die mehrlagige Beschichtung eine Anbindungsschicht und eine unmittelbar darüber abgeschiedene Verschleißschutzschicht umfasst,
wobei man die Anbindungsschicht mittels reaktivem oder nicht-reaktivem kathodischem Vakuum-Lichtbogenverdampfen (Arc-PVD) mehrlagig ausbildet, wobei jeweils zwei unmittelbar übereinander angeordnete Lagen unterschiedliche Zusammensetzungen aufweisen und die mehreren Lagen der Anbindungsschicht alternierende Lagen aus Titan-Aluminiumnitrid mit unterschiedlichen Zusammensetzungen umfassen, wobei sich Lagen mit einem Verhältnis von Ti:Al von (30 bis 36):(70 bis 64) und Lagen mit einem Verhältnis von Ti:Al von (40 bis 60):(60 bis 40), vorzugsweise von (47 bis 53):(53 bis 47) abwechseln, und
wobei man die Verschleißschutzschicht mittels High Power Impulse Magnetronsputtern (HIPIMS) einlagig oder mehrlagig ausbildet, wobei die eine oder mehreren Lagen der Verschleißschutzschicht jeweils von Carbiden, Nitriden, Oxiden, Carbonitriden, Oxicarbiden, Carboxinitriden von wenigstens zwei verschiedenen Metallen, ausgewählt unter Ti, V, Cr, Zr, Nb, Mo, Ru, Hf, Ta, W, Al, Si, Y, Li und B, und festen Lösungen davon gebildet werden.

2. Verfahren nach Anspruch 1, **dadurch gekennzeichnet, dass** die mehrlagige Anbindungsschicht wenigstens 4 und höchstens 300 übereinander angeordnete Lagen aufweist.

3. Verfahren nach einem der Ansprüche 1 bis 2, **dadurch gekennzeichnet, dass** man die Abscheidungsparameter für die Abscheidung der mehrlagigen Anbindungsschicht variiert, so dass innerhalb der mehrlagigen Anbindungsschicht die Vickers-Härte senkrecht zur Substratoberfläche in der Richtung vom Substrat zur Verschleißschutzschicht ansteigt und die Vickers-Härten innerhalb der mehrlagigen Anbindungsschicht im Bereich von 1800 HV bis 3500 HV, vorzugsweise 2000 HV bis 3300 HV, liegen,
wobei die während der Abscheidung der mehrlagigen Anbindungsschicht zu variierenden Abscheidungsparameter wenigstens das Biaspotential umfassen.

4. Verfahren nach einem der vorausgehenden Ansprüche, **dadurch gekennzeichnet, dass** innerhalb der mehrlagigen Anbindungsschicht der Elastizitätsmodul (E-Modul) senkrecht zur Substratoberfläche in der Richtung vom Substrat zur Verschleißschutzschicht ansteigt und die Werte des Elastizitätsmoduls (E-Modul) innerhalb der mehrlagigen Anbindungsschicht im Bereich von 380 GPa bis 550 GPa liegen.

5. Verfahren nach einem der vorausgehenden Ansprüche, **dadurch gekennzeichnet, dass** die mehrlagige Anbindungsschicht senkrecht zur Substratoberfläche eine Dicke im Bereich von 0,01 µm bis 1 µm aufweist und/oder die ein- oder mehrlagige Verschleißschutzschicht eine Dicke im Bereich von 0,4 µm bis 20 µm aufweist.

6. Verfahren nach einem der vorausgehenden Ansprüche, **dadurch gekennzeichnet, dass**, das Verhältnis der Dicke der ein- oder mehrlagigen Verschleißschutzschicht zur Dicke der mehrlagigen Anbindungsschicht wenigstens 2,0 beträgt.

7. Verfahren nach einem der vorausgehenden Ansprüche, **dadurch gekennzeichnet, dass** die Verschleißschutzbeschichtung mehrlagig ist und wenigstens 2, 4 oder 10 und höchstens 50, 100 oder 300, übereinander angeordneten Lagen aufweist.

8. Verfahren nach einem der vorausgehenden Ansprüche, **dadurch gekennzeichnet, dass** zwischen dem Substrat und der Anbindungsschicht wenigstens eine weitere Hartstofflage vorgesehen ist und/oder dass über der Verschleißschutzschicht wenigstens eine weitere Hartstofflage vorgesehen ist.

## Claims

1. Method for producing a coated tool comprising steps in which a base body made of hard metal, cermet, ceramic, steel or high speed steel is provided in a PVD process with a multi-layer coating having a total thickness of 1 µm to 20 µm, wherein the multi-layer coating comprises a bonding layer and an anti-wear protective layer deposited directly onto said bonding layer,
wherein said bonding layer is formed in multiple layers by means of reactive or non-reactive cathodic vacuum arc vapor deposition (Arc-PVD), wherein two layers disposed directly one over the other have different compositions and the multiple layers of the bonding layer comprise alternating layers of titanium-aluminium nitride having different compositions, wherein layers having a ratio of Ti:Al of (30 to 36):(70 to 64), and layers having a ratio of Ti:Al of (40 to 60): (60 to 40), preferably (47 to 53): (53 to 47) alternate, and
wherein the anti-wear protective layer is formed in one or more layers by means of high-power impulse magnetron sputtering (HIPIMS), wherein the one or more layers of the anti-wear protective layer are made of carbides, nitrides, oxides, carbonitrides, oxicarbides, carboxinitrides of at least two different metals selected from Ti, V, Cr, Zr, Nb, Mo, Ru, Hf, Ta, W, Al, Si, Y, Li and B, and solid solutions thereof.

2. Method according to Claim 1, **characterised in that** the multi-layer bonding layer comprises at least 4 and at most 300 layers disposed one over the other.

3. Method according to any one of Claims 1 to 2, **characterised in that** that the deposition parameters for the deposition of the multi-layer bonding layer are varied such that the Vickers hardness increases within the multi-layer bonding layer perpendicular to the substrate surface in the direction from the substrate to the anti-wear protective layer, and the Vickers hardnesses within the multi-layer bonding layer are in the range of 1800 HV to 3500 HV, preferably 2000 HV to 3300 HV, wherein the deposition parameters to be varied during the deposition of the multi-layer bonding layer include at least the bias potential.

4. Method according to any one of the preceding claims, **characterised in that** the modulus of elasticity (E modulus) increases within the multi-layer bonding layer perpendicular to the substrate surface in the direction from the substrate to the anti-wear protective layer, and the values for the modulus of elasticity (E modulus) within the multi-layer bonding layer are in the range of 380 GPa to 550 GPa.

5. Method according to any one of the preceding claims, **characterised in that** the multi-layer bonding layer perpendicular to the substrate surface has a thickness in the range of 0.01 µm to 1 µm and/or the single-layer or multi-layer anti-wear protective layer has a thickness in the range of 0.4 µm to 20 µm.

6. Method according to any one of the preceding claims, **characterised in that** the ratio of the thickness of the single-layer or multi-layer anti-wear protective layer to the thickness of the multi-layer bonding layer is at least 2.0.

7. Method according to any one of the preceding claims, **characterised in that** the anti-wear protective coating is multi-layered and comprises at least 2, 4 or 10 and at most 50, 100 or 300 layers disposed one over the other.

8. Method according to any one of the preceding claims, **characterised in that** at least one further hard material layer is provided between the substrate and the bonding layer and/or that at least one further hard material layer is provided over the anti-wear protective layer.

## Revendications

1. Procédé de production d'un outil à revêtement, comprenant les étapes dans lesquelles on pourvoit un corps de base en carbure cémenté, cermet, céramique, acier ou acier rapide d'un revêtement multicouche d'une épaisseur totale allant de 1 µm à 20 µm grâce à un procédé PVD, ledit revêtement multicouche comprenant une couche de liaison et une couche anti-usure déposée directement sur cette dernière,
dans lequel procédé on constitue la couche de liaison par évaporation par arc cathodique sous vide (Arc-PVD) réactive ou non réactive de façon qu'elle soit multicouche, deux couches superposées respectivement directement adjacentes présentant des compositions différentes et les couches multiples composant la couche de liaison comprenant des couches alternatives de nitrure de titane et d'aluminium de compositions différentes, avec une alternance de couches présentant un rapport Ti:Al de (30 à 36): (70 à 64) et de couches présentant un rapport Ti:Al de (40 à 60):(60 à 40), de préférence de (47 à 53):(53 à 47), et
dans lequel procédé on constitue la couche anti-usure par pulvérisation cathodique magnétron en régime d'impulsions de haute puissance (HIPIMS, High Power Impulse Magnetron Sputtering) de façon à être monocouche ou multicouche, la ou les couches composant la couche anti-usure composées chacune de carbures, nitrures, oxydes, nitrures de carbone, oxycarbures, carboxynitrures d'au moins deux métaux différents choisis parmi Ti, V, Cr, Zr, Nb, Mo, Ru, Hf, Ta, W, Al, Si, Y, Li et B, et de solutions solides de ces derniers.

2. Procédé selon la revendication 1, **caractérisé en ce que** la couche de liaison multicouche présente au moins 4 et au plus 300 couches superposées.

3. Procédé selon l'une des revendications 1 et 2, **caractérisé en ce qu'**on varie les paramètres de dépôt servant au dépôt de la couche de liaison multicouche de telle façon que la dureté Vickers aille croissant au sein de la couche de liaison multicouche perpendiculairement à la surface du substrat dans le sens allant du substrat vers la couche anti-usure, et les duretés Vickers au sein de la couche de liaison multicouche se situent dans la plage allant de 1800 HV à 3500 HV, de préférence de 2000 HV à 3300 HV, lesdits paramètres de dépôt subissant une variation pendant le dépôt de la couche de liaison multicouche comprenant au moins le potentiel de polarisation.

4. Procédé selon l'une des revendications précédentes, **caractérisé en ce que** le module d'élasticité (module E) va croissant au sein de la couche de liaison multicouche perpendiculairement à la surface du substrat dans le sens allant du substrat vers la couche anti-usure et les valeurs du module d'élasticité (module E) au sein de la couche de liaison multicouche se situent dans la plage allant de 380 GPa à 550 GPa.

5. Procédé selon l'une des revendications précédentes, **caractérisé en ce que** la couche de liaison multicouche présente, perpendiculairement à la surface du substrat, une épaisseur située dans la plage de 0,01 µm à 1 µm et/ou la couche anti-usure monocouche ou multicouche présente une épaisseur située dans la plage de 0,4 µm à 20 µm.

6. Procédé selon l'une des revendications précédentes, **caractérisé en ce que** le rapport entre l'épaisseur de la couche anti-usure monocouche ou multicouche et l'épaisseur de la couche de liaison multicouche est d'au moins 2,0.

7. Procédé selon l'une des revendications précédentes, **caractérisé en ce que** le revêtement de couche anti-usure est multicouche et présente au moins 2, 4 ou 10 et au plus 50, 100 ou 300 couches superposées.

8. Procédé selon l'une des revendications précédentes, **caractérisé en ce qu'**il est prévu au moins une autre couche de matériau dur entre le substrat et la couche de liaison et/ou **en ce qu'**il est prévu au moins une autre couche de matériau dur sur la couche anti-usure.
